# EUROPEAN PATENT APPLICATION

(11) **EP 1 683 886 A2**
(43) Date of publication of application: **26.07.2006**
(21) Application number: 06001097.2
(22) Date of filing: 19.01.2006
(51) Int. Cl.: C23C 14/24, C23C 14/54

(54) **Vacuum vapor deposition apparatus**

(30) Priority: 21.01.2005 JP 2005013673; 09.12.2005 JP 2005355652
(71) Applicant: MITSUBISHI HEAVY INDUSTRIES, LTD., Tokyo 108-8215 (JP)
(72) Inventor: Sato, Keiichi Hiroshima Research & Dvpt Center, Nishi-ku, Hiroshima-shi, Hiroshima (JP); Kobayashi, Toshiro Hiroshima Research& Dvpt Center, Nishi-ku, Hiroshima-shi, Hiroshima (JP); Kato, Mitsuo Hiroshima Research & Dvpt Center, Nishi-ku, Hiroshima-shi, Hiroshima (JP); Kamikawa, Susumu, Minato-ku, Tokyo (JP); Wada, Kouzou, Minato-ku, Tokyo (JP)
(74) Representative: HOFFMANN EITLE

(57) **Abstract**

A crucible (22A) is a monolithic structure extending over an entire area of a vaporizing chamber (16A) and has at least one slit groove (32A) provided in the upper surface (31) thereof. The at least one slit groove (32A) has a length from one end of the upper surface of the crucible to other end thereof. The at least one slit groove (32A) is used as a portion for containing the evaporation material (dopant material (30A) or the like). Alternatively, a crucible is a monolithic structure extending over the entire area of the vaporizing chamber (16A) and has a plurality of holes provided in the upper surface thereof. The holes are used as portions for containing the evaporation material. Further, the crucible is divided into a plurality of regions, and individual electric heaters are provided under the lower surface of the crucible for the respective regions, whereby temperature can be individually controlled for the respective regions by the electric heaters.

## Description

### Technical Field

The present invention relates to a vacuum vapor deposition apparatus which evaporates and deposits an evaporation material such as an organic material on a surface of a workpiece such as a substrate for a flat panel display to form a thin film.

### Background Art

In a vacuum vapor deposition apparatus, an evaporation material is contained in a crucible provided in a vaporizing chamber, and this evaporation material is heated by radiant heat from side walls (hot walls) of the vaporizing chamber to be vaporized, whereby the evaporation material is deposited on a surface of a workpiece to form a thin film.

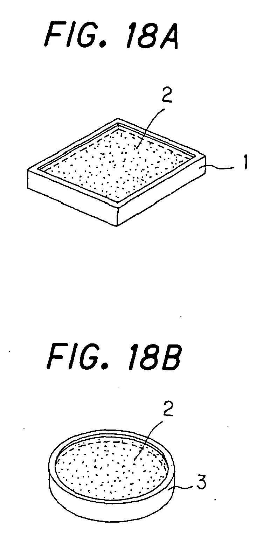

In conventional vacuum vapor deposition apparatus, crucibles such as illustrated in Figs. 18A and 18B are used. It should be noted that publicly known related art documents which disclose vacuum vapor deposition apparatus using known crucibles include, for example, Patent Document 1 below. A crucible 1 illustrated in Fig. 18A is a simple box-type container and intended to contain an evaporation material 2 as a raw material for vacuum vapor deposition inside thereof. A crucible 3 illustrated in Fig. 18B is a simple cylinder-type container and intended to contain the evaporation material 2 inside thereof. The width of a containing portion of the box-type crucible 1 and the diameter of a containing portion of the cylinder-type crucible 3 are, for example, approximately 30 mm. In order to deal with an increase in the size of a to-be-coated region of a workpiece using such a known crucible 1 or 3, it is necessary to arrange a plurality of box-type crucibles 1 or a plurality of cylinder-type crucibles 3.

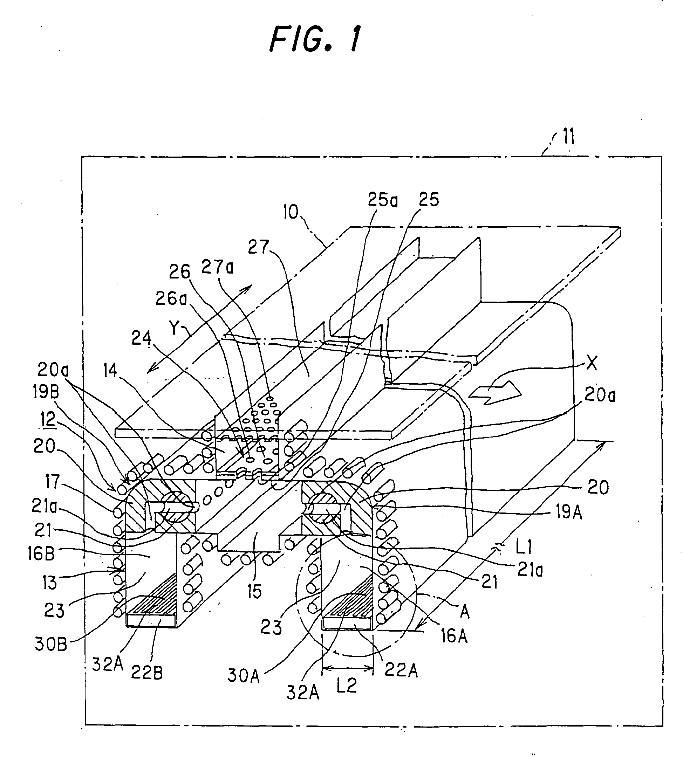

For example, in recent years, vacuum vapor deposition apparatus are used for not only the deposition of metal materials (formation of a thin metal film) but also the deposition of organic materials (formation of a thin organic film), the co-deposition of a plurality of organic materials (formation of a thin polymer film, e.g., an organic electroluminescence element (hereinafter abbreviated to an organic EL element) for a flat panel display (hereinafter abbreviated to an FPD), and the like. Further, with the recent popularization of FPDs , the sizes of FPD substrates are increasing. With this increase in the sizes of the FPD substrates, the sizes of to-be-coated regions of the FPD substrates on which deposition is performed at a time are also increasing (see Fig. 1).

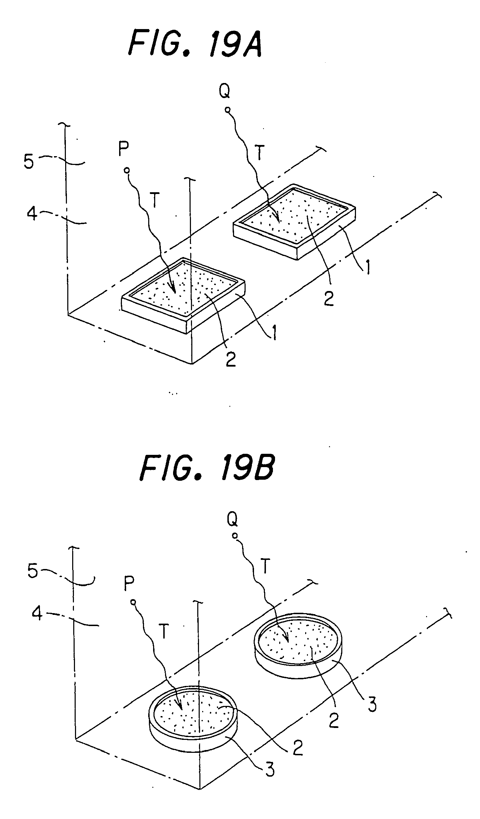

Accordingly, in order to deal with such an increase in the sizes of the to-be-coated regions of the FPD substrates, it is necessary to arrange a plurality of box-type crucibles 1 or a plurality of cylinder-type crucibles 3 in a vaporizing chamber 4 along the longitudinal direction (direction perpendicular to a FPD substrate transport direction) of a to-be-coated region of an FPD substrate in a dispersed manner as illustrated in Fig. 19A or 19B. Side walls (hot walls) 5 of the vaporizing chamber 4 are heated by electric heaters (not shown). The evaporation material (organic material) 2 contained in the crucibles 1 or 3 is vaporized by radiant heating using radiant heat T from the hot walls 5. In this case, the evaporation material 2 is not only directly radiantly heated but also heated by heat conducted from the crucibles 1 or 3 radiantly heated.

Patent Document 1; Japanese Patent Publication Laid-Open No. S61-73875

However, in the case where a plurality of known box-type crucibles 1 or a plurality of known cylinder-type crucibles 3 are arranged as illustrated in Fig. 19A or 19B, there are the following problems.

(1) The heating surface area of one known crucible 1 or 3, i.e. , the area thereof which is in contact with the evaporation material 2, is small. Accordingly, in order to obtain a desired vaporized amount of the evaporation material 2, it is necessary to heat the hot walls 5 to a higher temperature by increasing the capacities of electric heaters or to arrange a larger number of crucibles 1 or 3. Thus, there arise problems such as an increase in the size of an evaporation source, an increase in the effort of arranging the crucibles, and an increase in the cost of a system.
(2) If a plurality of crucibles 1 or 3 is arranged in a dispersed manner, unevenness in the vaporization of the evaporation material 2 is prone to occur. As a result, the film thickness distribution of a thin film formed on a substrate becomes non-uniform. Even if the temperature of the hot walls 5 is controlled using electric heaters, there are cases where a difference occurs between, for example, temperature (e.g., 350°C) at part P of the hot wall 5 and temperature (e.g. , 300°C) at part Q thereof as illustrated in Figs. 19A and 19B. In this case, the evaporation material 2 in the crucible 1 or 3 on the front side mainly receives radiant heat T from part P to vaporize, and the evaporation material 2 in the crucible 1 or 3 on the back side mainly receives radiant heat T from part Q to vaporize. Accordingly, there occurs unevenness (difference) in the vaporized amount of the evaporation material 2 between the crucible 1 or 3 on the front side and the crucible 1 or 3 on the back side. Thus, in order to cope with this, it is necessary to arrange a large number of crucibles 1 or 3 at smaller intervals by decreasing the sizes of the crucibles 1 or 3. In this case, there also arise problems such as an increase in the effort of arranging the crucibles and an increase in the cost of a system. In particular, in vacuum vapor deposition apparatus for organic EL, such problems are prone to occur because the sizes of to-be-coated regions have increased with an increase in the sizes of FPD substrates.
(3) In the case where a small amount of the evaporation material 2 is vaporized, i.e., in the case
where the evaporation material 2 of which amount is originally small is vaporized or where the amount of the evaporation material 2 decreases due to vaporization to become small, it makes a distance between the periphery portion of the evaporation material 2 where vaporization proceeds relatively quickly and the inner surfaces of the crucibles 1 or 3, and the efficiency of heat conduction from the crucibles 1 or 3 to the evaporation material 2 becomes low. Thus, unevenness in the vaporized amount of the evaporation material 2 among the crucibles 1 or 3 is prone to occur, and the distribution of a film thickness is prone to become non-uniform. Accordingly, in order to cope with this, it is also necessary to arrange a large number of crucibles 1 or 3. As a result, there arise problems such as an increase in the effort of arranging the crucibles and an increase in the cost of a system. In particular, in vacuum vapor deposition apparatus for organic EL, such problems are prone to occur, because a very thin film having a thickness of , for example, approximately 400 angstroms is formed and therefore the amounts of host and dopant materials, which are organic materials and used to form this film, are very small (e.g., approximately 2 g).

Accordingly, in view of the above-described circumstances, an object of the present invention is to provide a vacuum vapor deposition apparatus comprising a crucible having a construction with which an increase in the size of a to-be-coated region of a workpiece, a small amount of the evaporation material, and the like can be easily dealt with at low cost.

### Summary of the Invention

A vacuum vapor deposition apparatus of a first aspect of the present invention which achieves the above-described object is a vacuum vapor deposition apparatus in which an evaporation material is contained in a crucible provided in a vaporizing chamber and hot walls being side walls of the vaporizing chamber heat the evaporation material by radiant heat from the hot walls to vaporize (the case of sublimation is also included) the evaporation material and thereby the evaporation material is deposited on a surface of a workpiece to form a thin film. The crucible is comprised of a monolithic structure extending over an entire area of the vaporizing chamber and has a plurality of grooves in an upper surface thereof. The grooves have lengths from one end of the upper surface of the crucible to the other end thereof and serve as portions for containing the evaporation material.
It should be noted that a sublimation material which is sublimed by heating to vaporize is suitable as the evaporation material contained in the plurality of grooves. Further, grooves which are narrow openings, e.g., slit grooves, are suitable as the plurality of grooves.

A vacuum vapor deposition apparatus of a second aspect of the present invention is a vacuum vapor deposition apparatus in which an evaporation material is contained in a crucible provided in a vaporizing chamber and hot walls being side walls of the vaporizing chamber heat the evaporation material by radiant heat from the hot walls to vaporize (the case of sublimation is also included) the evaporation material and thereby the evaporation material is deposited on a surface of a workpiece to form a thin film. The crucible is comprised of a monolithic structure extending over an entire area of the vaporizing chamber and has a groove in an upper surface thereof. The groove has a length from one end of the upper surface of the crucible to the other end thereof and serves as a portion for containing the evaporation material.
It should be noted that a molten material which is melted by heating to vaporize is suitable as the evaporation material contained in the groove.

A vacuum vapor deposition apparatus of a third aspect of the present invention is a vacuum vapor deposition apparatus in which an evaporation material is contained in a crucible provided in a vaporizing chamber and hot walls being side walls of the vaporizing chamber heat the evaporation material by radiant heat from the hot walls to vaporize (the case of sublimation is also included) the evaporation material and thereby the evaporation material is deposited on a surface of a workpiece to form a thin film. The crucible is comprised of a plurality of pieces arranged in a cluster to extend over an entire area of the vaporizing chamber and has a plurality of grooves in an upper surface thereof. The grooves have lengths from one end of the upper surface of the crucible to the other end thereof and serve as portions for containing the evaporation material.

A vacuum vapor deposition apparatus of a fourth aspect of the present invention is a vacuum vapor deposition apparatus in which an evaporation material is contained in a crucible provided in a vaporizing chamber and hot walls being side walls of the vaporizing chamber heat the evaporation material by radiant heat from the hot walls to vaporize (the case of sublimation is also included) the evaporation material and thereby, the evaporation material is deposited on a surface of a workpiece to form a thin film. The crucible is comprised of a monolithic structure extending over an entire area of the vaporizing chamber or is comprised of a plurality of pieces arranged in a cluster to extend over the entire area of the vaporizing chamber, and has a plurality of holes in an upper surface thereof. The holes serve as portions for containing the evaporation material.

A vacuum vapor deposition apparatus of a fifth aspect of the present invention is the vacuum vapor deposition apparatus of any one of the first to fourth aspects of the present invention in which the crucible is divided into a plurality of regions. Individual heating means are provided under a lower surface of the crucible for the respective regions. Thus, temperature can be individually controlled for the respective regions by the heating means.

A vacuum vapor deposition apparatus of a sixth aspect of the present invention is a vacuum vapor deposition apparatus in which an evaporation material is contained in a crucible provided in a vaporizing chamber and hot walls being side walls of the vaporizing chamber heat the evaporation material by radiant heat from the hot walls to vaporize (the case of sublimation is also included) the evaporation material and thereby the evaporation material is deposited on a surface of a workpiece to form a thin film. The crucible is comprised of a monolithic structure extending over an entire area of the vaporizing chamber, has a long narrow shape extending along a width direction of the workpiece, and has at least one groove in an upper surface thereof. The at least one groove extends along a longitudinal direction of the crucible and serves as a portion for containing the evaporation material.

A vacuum vapor deposition apparatus of a seventh aspect of the present invention is a vacuum vapor deposition apparatus In which an evaporation material is contained in a crucible provided in a vaporizing chamber and hot walls being side walls of the vaporizing chamber heat the evaporation material by radiant heat from the hot walls to vaporize (the case of sublimation is also included) the evaporation material and thereby the evaporation material is deposited on a surface of a workpiece to form a thin film. The crucible is comprised of a monolithic structure extending over an entire area of the vaporizing chamber, has a long narrow shape extending along a width direction of the workpiece, and has a plurality of grooves in an upper surface thereof. The grooves extend along a direction perpendicular to a longitudinal direction of the crucible and serve as portions for containing the evaporation material.

A vacuum vapor deposition apparatus of a eighth aspect of the present invention is a vacuum vapor deposition apparatus in which an evaporation material is contained in a crucible provided in a vaporizing chamber and hot walls being side walls of the vaporizing chamber heat the evaporation material by radiant heat from the hot walls to vaporize (the case of sublimation is also included) the evaporation material and thereby the evaporation material is deposited on a surface of a workplace to form a thin film. The crucible is comprised of a monolithic structure extending over an entire area of the vaporizing chamber, has a long narrow shape extending along a width direction of the workpiece, and has a plurality of holes in an upper surface thereof. The holes serve as portions for containing the evaporation material.

A vacuum vapor deposition apparatus of a ninth aspect of the present invention is the vacuum vapor deposition apparatus of any one of the sixth to eighth aspects of the present invention in which the crucible is divided into a plurality of regions at least in the longitudinal direction. Individual heating means are provided under a lower surface of the crucible for the respective regions. Thus, temperature can be individually controlled for the respective regions by the heating means.

A vacuum vapor deposition apparatus of a tenth aspect of the present invention is the vacuum vapor deposition apparatus of any one of the sixth to ninth aspects of the present invention in which the evaporation material is an organic material and in which the workpiece is a substrate for a flat panel display. The organic material is deposited on a surface of the substrate to form a thin film of an organic electroluminescence element.

A vacuum vapor deposition apparatus of an eleventh aspect of the present invention is the vacuum vapor deposition apparatus of the sixth to ninth aspects of the present invention in which the evaporation material is an organic material and the workpiece is a substrate for a lighting device. The organic material is deposited on a surface of the substrate to form a thin film of an organic electroluminescence element.

According to a twelfth aspect of the present invention which achieves the aforementioned object, there is provided a method of manufacturing a thin film of an organic electroluminescence element using the vacuum vapor deposition apparatus of any one of the fifth and ninth aspects of the present invention. An organic material is used as the evaporation material. Temperatures are measured for the respective regions of the crucible, and outputs of the heating means are individually controlled based on the measured temperatures of the respective regions so that the temperatures of the respective regions become constant.

In the vacuum vapor deposition apparatus of the first and second aspects of the present invention, the crucible is comprised of a monolithic structure extending over the entire area of the vaporizing chamber and has at least one groove in the upper surface thereof. The at least one groove has a length from one end of the upper surface of the crucible to the other end thereof and serves as a portion for containing the evaporation material. Accordingly, the heating surface area (area where the crucible is in contact with the evaporation material) of the crucible becomes large. Thus, a desired vaporized amount of the evaporation material can be obtained without heating the hot walls to higher temperature, arranging a larger number of crucibles, and the like. Further, since the crucible is a monolithic structure, even if there are differences in temperature among positions in the hot walls, temperature is uniform over the entire crucible due to heat conduction in portions (mound portions) of the upper surface of the crucible where the at least one groove is not formed and portions under the at least one groove. Accordingly, it is possible to prevent unevenness in the vaporization of the evaporation material and to make the film thickness distribution of the workpiece uniform. Moreover, a small amount of the evaporation material can also be easily dealt with by appropriately setting the number and dimensions (width, depth, and the like) of the at least one groove. Accordingly, an increase in the size of a to-be-coated region of the workpiece, a small amount of the evaporation material, and the like can be easily dealt with at low cost without heating the hot walls to a higher temperature, arranging a larger number of crucibles, and the like. Thus, the cost of the apparatus can also be reduced.

In the vacuum vapor deposition apparatus of the third aspect of the present invention, the crucible is comprised of a plurality of pieces arranged in a cluster to extend over the entire area of the vaporizing chamber and has a plurality of grooves in the upper surface thereof . The grooves have lengths from one end of the upper surface of the crucible to other end thereof and serve as portions for containing the evaporation material. Accordingly, for example, in the case where it is difficult to form a large monolithic crucible for a large workpiece such as a large-sized substrate, an equivalent to a large monolithic crucible can be provided by arranging a plurality of crucibles in a cluster over the entire area of the vaporizing chamber. Thus, effects equivalent to those of the aforementioned first and second aspects of the present invention can be obtained.

In the vacuum vapor deposition apparatus of the fourth aspect of the present invention, the crucible is comprised of a monolithic structure extending over the entire area of the vaporizing chamber or is comprised of a plurality of pieces arranged in a cluster to extend over the entire area of the vaporizing chamber, and has a plurality of holes in the upper surface thereof. The holes serve as portions for containing the evaporation material. Accordingly, the heating surface area (area where the crucible is in contact with the evaporation material) of the crucible becomes large. Thus, a desired vaporized amount of the evaporation material can be obtained without heating the hot walls to a higher temperature, arranging a larger number of crucibles, and the like. Further, since the crucible is a monolithic structure or an almost monolithic structure, even if there are differences in temperature among positions in the hot walls, the temperature is uniform over the entire crucible due to heat conduction in portions (mound portions) of the upper surface of the crucible where the holes are not formed and portions under the holes. Accordingly, it is possible to prevent unevenness in the vaporization of the evaporation material and to make the film thickness distribution of the workpiece uniform. Moreover, a small amount of the evaporation material can also be easily dealt with by appropriately setting the number and dimensions (diameter, depth, and the like) of the holes. Accordingly, an increase in the size of a to-be-coated region of the workpiece, a small amount of the evaporation material, and the like can be easily dealt with at low cost without heating the hot walls to a higher temperature, arranging a larger number of crucibles , and the like. Thus, the cost of the apparatus can also be reduced. Further, in this fourth aspect, even if the amount of the evaporation material is very small, the holes can be provided in a dispersed manner over the entire upper surface of the crucible. Accordingly, this fourth aspect is particularly effective for the case where the amount of the evaporation material is small, in comparison with the case where grooves are provided as in the aforementioned first aspect.

In the vacuum vapor deposition apparatus of the fifth aspect of the present invention, the crucible is divided into a plurality of regions, and individual heating means are provided under the lower surface of the crucible for the respective regions, whereby temperature can be individually controlled for the respective regions by the heating means. Accordingly, for each region, the temperature of the crucible is controlled and the temperature of the evaporation material is controlled. Thus, it is possible to more reliably prevent unevenness in the vaporization of the evaporation material. Consequently, it is possible to more reliably deal with an increase in the size of a to-be-coated region of the workpiece, a small amount of the evaporation material, and the like.

In the vacuum vapor deposition apparatus of the sixth aspect of the present invention, the crucible is comprised of a monolithic structure extending over the entire area of the vaporizing chamber, has a long narrow shape extending along the width direction of the workpiece, and has at least one groove in the upper surface thereof. The at least one groove extends along the longitudinal direction of the crucible and serves as a portion for containing the evaporation material. Accordingly, the heating surface area (area where the crucible is in contact with the evaporation material) of the crucible becomes large. Thus, a desired vaporized amount of the evaporation material can be obtained without heating the hot walls to a higher temperature, arranging a larger number of crucibles, and the like. Further, since the crucible is a monolithic structure, even if there are differences in temperature among positions in the hot walls in the longitudinal direction, the temperature is uniform over the entire crucible due to heat conduction in portions (mound portions) of the upper surface of the crucible where the at least one groove is not formed and portions under the at least one groove. Accordingly, it is possible to prevent unevenness in the vaporization of the evaporation material in the longitudinal direction and to make the film thickness distribution of the workpiece uniform. Moreover, a small amount of the evaporation material can also be easily dealt with by appropriately setting the number and dimensions (width, depth, and the like) of the at least one groove. Accordingly, an increase in the size of a to-be-coated region of the workpiece, a small amount of the evaporation material, and the like can be easily dealt with at low cost without heating the hot walls to a higher temperature, arranging a larger number of crucibles, and the like. Thus, the cost of the apparatus can also be reduced. In particular, it should be noted that in the case where the amount of the evaporation material is very small, If the at least one groove is formed along the direction perpendicular to the longitudinal direction as in the undermentioned seventh aspect of the present invention, the intervals between grooves in the longitudinal direction become too large, and unevenness in the vaporization of the evaporation material is prone to occur. However, in this sixth aspect, since the at least one groove is formed along the longitudinal direction, such a problem does not occur. This sixth aspect is also advantageous at this point.

In the vacuum vapor deposition apparatus of the seventh aspect of the present invention, the crucible is comprised of a monolithic structure extending over the entire area of the vaporizing chamber, has a long narrow shape extending along the width direction of the workpiece, and has a plurality of grooves in the upper surface thereof. The grooves extend along the direction perpendicular to the longitudinal direction of the crucible and serve as portions for containing the evaporation material. Accordingly, the heating surface area (area where the crucible is in contact with the evaporation material) of the crucible becomes large. Thus, a desired vaporized amount of the evaporation material can be obtained without heating the hot walls to a higher temperature, arranging a larger number of crucibles, and the like. Further, since the crucible is a monolithic structure, even if there are differences in temperature among positions in the hot walls in the longitudinal direction, the temperature is uniform over the entire crucible due to heat conduction in portions (mound portions) of the upper surface of the crucible where the grooves are not formed and portions under the grooves. Accordingly, it is possible to prevent unevenness in the vaporization of the evaporation material in the longitudinal direction and to make the film thickness distribution of the workpiece uniform. Moreover, a small amount of the evaporation material can also be easily dealt with by appropriately setting the number and dimensions (width, depth, and the like) of the grooves. Accordingly, an increase in the size of a to-be-coated region of the workpiece, a small amount of the evaporation material, and the like can be easily dealt with at low cost without heating the hot walls to a higher temperature, arranging a larger number of crucibles, and the like. Thus, the cost of the apparatus can also be reduced.

In the vacuum vapor deposition apparatus of the eighth aspect of the present invention, the crucible is comprised of a monolithic structure extending over the entire area of the vaporizing chamber, has a long narrow shape extending along the width direction of the workpiece, and has a plurality of holes in the upper surface thereof. The holes serve as portions for containing the evaporation material. Accordingly, the heating surface area (area where the crucible is in contact with the evaporation material) of the crucible becomes large. Thus, a desired vaporized amount of the evaporation material can be obtained without heating the hot walls to a higher temperature, arranging a larger number of crucibles, and the like. Further, since the crucible is a monolithic structure, even if there are differences in temperature among positions in the hot walls in the longitudinal direction of the crucible, the temperature is uniform over the entire crucible due to heat conduction in portions (mound portions) of the upper surface of the crucible where the holes are not formed and portions under the holes. Accordingly, it is possible to prevent unevenness in the vaporization of the evaporation material in the longitudinal direction and to make the film thickness distribution of the workpiece uniform. Moreover, a small amount of the evaporation material can also be easily dealt with by appropriately setting the number and dimensions (diameter, depth, and the like) of the holes. Accordingly, an increase in the size of a to-be-coated region of the workpiece, a small amount of the evaporation material, and the like can be easily dealt with at low cost without heating the hot walls to a higher temperature, arranging a larger number of crucibles, and the like. Thus, the cost of the apparatus can also be reduced. Further, in this eighth aspect, even if the amount of the evaporation material is very small, the holes can be provided in a dispersed manner over the entire upper surface of the crucible. Accordingly, this eighth aspect is particularly effective for the case where the amount of the evaporation material is small, in comparison with the case where grooves are provided as in the aforementioned sixth and seventh aspects.

In the vacuum vapor deposition apparatus of the ninth aspect of the present invention, the crucible is divided into a plurality of regions at least in the longitudinal direction, and individual heating means are provided under the lower surface of the crucible for the respective regions, whereby temperature can be individually controlled for the respective regions by the heating means. Accordingly, for each region, the temperature of the crucible is controlled and the temperature of the evaporation material is controlled. Thus, it is possible to more reliably prevent unevenness in the vaporization of the evaporation material in the longitudinal direction. Consequently, it is possible to more reliably deal with an increase in the size of a to-be-coated region of the workpiece, a small amount of the evaporation material, and the like.

In the vacuum vapor deposition apparatus of the tenth and eleventh aspects of the present invention, the evaporation material is an organic material, and the workpiece is a substrate for a flat panel display or a substrate for a lighting device. The organic material is deposited on a surface of the substrate to form a thin film of an organic electroluminescence element. Accordingly, effects similar to those of any one of the aforementioned sixth to ninth aspects can be obtained. Thus it is also possible to easily deal with an increase in the size of the substrate for a flat panel display or the substrate for a lighting device. In particular, a useful vacuum vapor deposition apparatus for organic EL can be realized when applied to a large-sized substrate for FPD or a large-sized substrate for a lighting device.

According to the method of the twelfth aspect of the present invention, which is a method of manufacturing a thin film of an organic electroluminescence element, in the vacuum vapor deposition apparatus of any one of the fifth and ninth aspects of the present invention, an organic material is used as the evaporation material. Further, the crucible of the vacuum vapor deposition apparatus is divided into a plurality of regions. Temperatures are measured for the respective regions, and outputs of the heating means such as heaters are individually controlled based on the measured temperatures of the respective regions so that the temperatures of the respective regions become constant. Accordingly, for each region, the temperature of the crucible is controlled and the temperature of the evaporation material is controlled. Thus, it is possible to more reliably prevent unevenness in the vaporization of the evaporation material in the longitudinal direction. Consequently, it is possible to more reliably deal with an increase in the size of a to-be-coated region of the workpiece, a small amount of the evaporation material, and the like.

### Brief Description of the Drawings

Fig. 1 is a perspective view illustrating a construction of a vacuum vapor deposition apparatus according to a first embodiment of the present invention;
Fig. 2A is a view illustrating another construction of a spool shutter, and Fig. 2B is a view for explaining the operation thereof;
Fig. 3 is an enlarged perspective view of part A of Fig. 1;
Fig. 4A is a cross-sectional view (plan view of a crucible) as seen from the direction of arrows B of Fig. 3, and Fig. 4B is an enlarged cross-sectional view taken along the line C-C of Fig. 4A;
Fig. 5 is a construction diagram (plan view of the crucible) for the case where slit grooves are formed along the direction perpendicular to the longitudinal direction of the crucible;
Fig. 6A is a plan view of a crucible having one slit groove, and Fig. 6B is an enlarged cross-sectional view taken along the line C'-C' of Fig. 6A;
Fig. 7 is a perspective view illustrating the construction of an essential part of a vacuum vapor deposition apparatus according to a second embodiment of the present invention;
Fig. 8 is a cross-sectional view (plan view of electric heaters) as seen from the direction of arrows D of Fig. 7;
Fig. 9 is a flowchart for explaining an example of temperature control of the crucible;
Fig. 10 is a construction diagram for the case where the crucible and the heater stage are provided as separated structures:
Fig. 11 is a view (plan view of the electric heaters) illustrating another example of the arrangement of the electric heaters;
Fig. 12 is a perspective view illustrating the construction of an essential part of a vacuum vapor deposition apparatus according to a third embodiment of the present invention;
Fig. 13A is a cross-sectional view (plan view of the crucible) as seen from the direction of arrows E of Fig. 12, and Fig. 13B is an enlarged cross-sectional view taken along the line F-F of Fig. 13A;
Fig. 14 is a view (plan view of the crucible) illustrating another example of the arrangement of holes;
Fig. 15 is a perspective view illustrating the construction of an essential part of a vacuum vapor deposition apparatus according to a fourth embodiment of the present invention;
Fig. 16 is a perspective view illustrating another construction example of a crucible;
Fig. 17 is a perspective view illustrating another construction example of a crucible;
Figs. 18A and 18B are perspective views illustrating the constructions of conventional crucibles;
Figs. 19A and 19B are perspective views illustrating examples in which a plurality of the conventional crucibles are provided.

### Detailed Description

Hereinafter, embodiments of the present invention will be described in detail based on drawings.

### [FIRST EMBODIMENT]

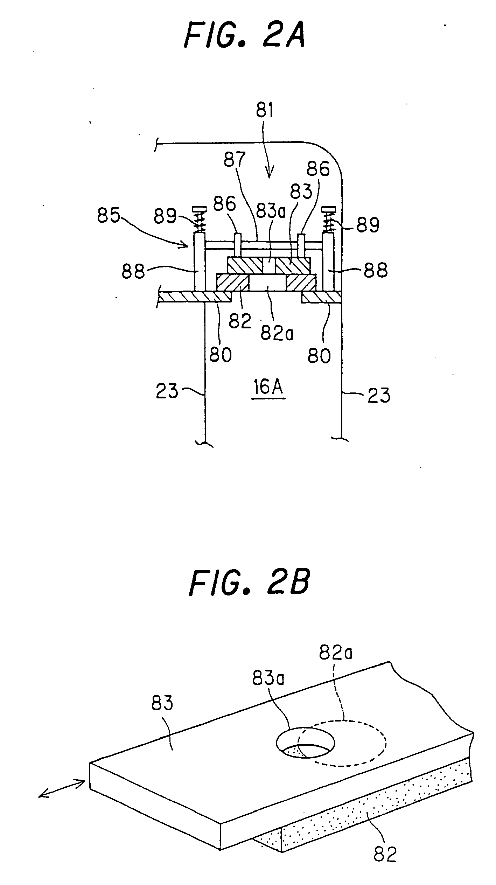

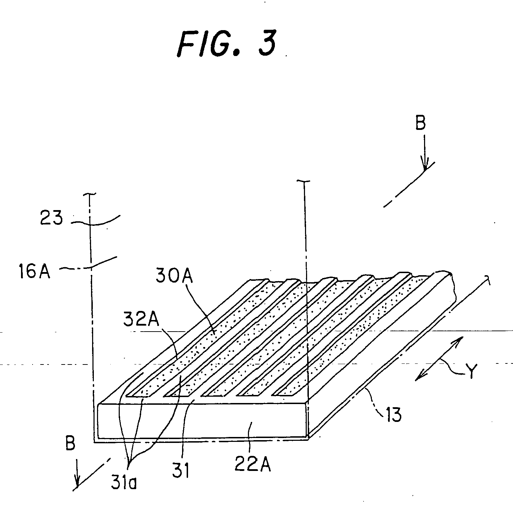

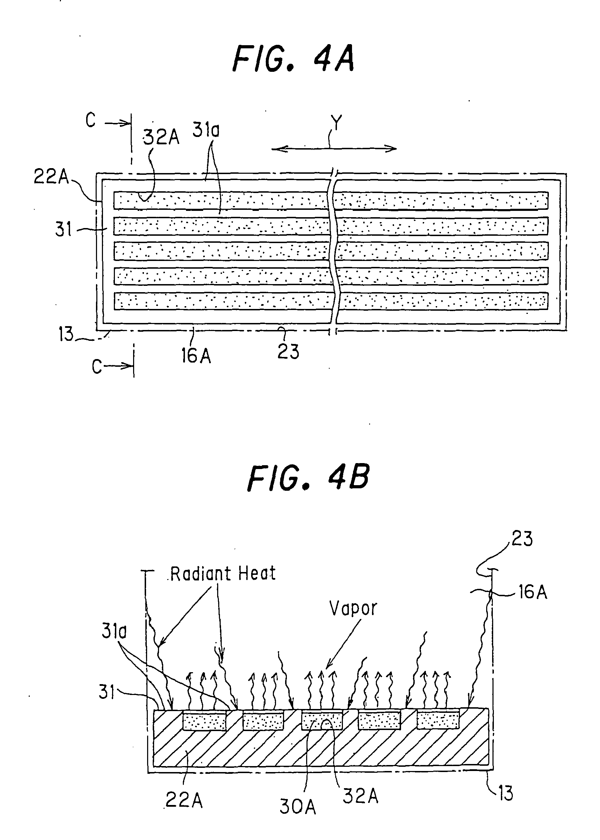

Fig. 1 is a perspective view illustrating the construction of a vacuum vapor deposition apparatus according to a first embodiment of the present invention. Fig. 3 is an enlarged perspective view of part A of Fig. 1. Fig. 4A is a cross-sectional view (plan view of a crucible) as seen from the direction of arrows B of Fig. 3. Fig. 4B is an enlarged cross-sectional view taken along the line C-C of Fig. 4A. It should be noted that Figs. 2A and 2B are views illustrating another example of the construction of a spool shutter in the vacuum vapor deposition apparatus of the first embodiment.

As illustrated in Fig. 1, the vacuum vapor deposition apparatus of the first embodiment includes a main system 12 of an vapor deposition apparatus and a substrate transport system (not shown) in a vacuum chamber 11 and is intended for co-deposition and organic EL. The main system 12 serves as an evaporation source. The substrate transport system is provided above the main system 12.

The inside of the vacuum chamber 11 is maintained in a low-pressure state (vacuum) by a vacuum pump (not shown). Accordingly, of course, the inside of the main system 12 and the like are also maintained in a vacuum. Further, while an FPD substrate 10 (e.g., glass substrate) as a workpiece is being horizontally transported in a substrate transport direction indicated by arrow X at a predetermined speed under this vacuum by the substrate transport system, the vapor of evaporation material supplied from the main system 12 is absorbed to (deposited on) a to-be-coated region of a surface (lower surface in the drawing) of this FPD substrate 10, thus forming a thin film.

The main system 12 is intended for co-deposition using two kinds of organic materials and therefore includes a chamber 13 (vacuum container), which has such a shape that a lower portion thereof is branched into two portions and is made of copper or the like. This chamber 13 is a so-called hot wall chamber. The chamber 13 is heated by electric heaters 17 attached to a peripheral portion thereof, whereby the temperature thereof is adjusted to a temperature suitable for the vaporization of the evaporation material. Further, inside the chamber 13, a deposition chamber 14, a mixing chamber 15, and vaporizing chambers 16A and 16B are provided in this order from top to bottom.

The vaporizing chamber 16A is placed on a backward side of the substrate transport direction, and the vaporizing chamber 16B is placed on a forward side of the substrate transport direction. Further, a crucible 22A is provided in the vaporizing chamber 16A, and a crucible 22B is provided in the vaporizing chamber 16B. Although a detailed description will be given later, each of these crucibles 22A and 22B has a long narrow shape extending along the plate width direction (direction (direction of arrow Y) perpendicular to the substrate transport direction: hereinafter simply referred to as the "plate width direction") of the FPD substrate 10. One crucible 22A contains an organic dopant material 30A as an evaporation material, and the other crucible 22B contains an organic host material 30B as an evaporation material.

A spool shutter 19A is provided between the vaporizing chamber 16A and the mixing chamber 15, and a spool shutter 19B is also provided between the vaporizing chamber 16B and the mixing chamber 15. Each of the spool shutters 19A and 19B includes a shutter block 20 and a plurality of shutter shafts 21 rotatably inserted in the shutter block 20 in series. In the shutter block 20, vapor holes 20a are formed which communicate with the vaporizing chamber 16A (in the case of the spool shutter 19A) or the vaporizing chamber 16B (in the case of the spool shutter 19B) and the mixing chamber 15. In the shutter shafts 21, vapor holes 21a are formed at positions where the vapor holes 21a can be communicated with the vapor holes 20a of the shutter block 20. Further, both of the plurality of vapor holes 20a and the plurality of vapor holes 21a are provided in the plate width direction. Accordingly, the amount of evaporation material vapor flowing through each of the vapor holes 20a and 21b can be adjusted so that the distribution of the amount of evaporation material vapor in the plate width direction becomes uniform, by adjusting the rotational position of each shutter shaft 21 to adjust the relative position between the vapor hole 21a of each shutter shaft 21 and the corresponding vapor hole 20a of the relevant shutter block 20.

It should be noted that as a spool shutter in the vacuum vapor deposition apparatus of the first embodiment, one having a construction illustrated in Figs. 2A and 2B may be used. Although one vaporizing chamber 16A side will be illustrated and described here, a spool shutter having a construction illustrated in Figs. 2A and 2B may also be used for the other vaporizing chamber 16B.

As illustrated in Fig. 2A, a spool shutter 81 is in contact with side walls (hot walls) 23 to constitute an upper wall of the vaporizing chamber 16A, and is placed on a support plate 80 which has an opening portion along the longitudinal direction in a central portion thereof. To be more detailed, the spool shutter 81 includes a planar fixed plate 82 fixed to the support plate 80 and placed to cover the opening portion of the support plate 80, a planar movable plate 83 placed on the surface of the fixed plate 82 to be slidable on the surface thereof, pressing mechanisms 85 for pressing the movable plate 83 against the fixed plate 82 in such a manner that the movable plate 83 is slidable, and a shifting device (not shown) for causing the movable plate 83 to slide along the surface of the fixed plate 82. In the fixed plate 82, a plurality of vapor holes 82a are formed which are arranged at intervals of predetermined length in the longitudinal direction. On the other hand, in the movable plate 83 , a plurality of vapor holes 83a are formed which are arranged at intervals equal to those of the vapor holes 82a and which have smaller opening areas than the vapor holes 82a. It should be noted that the fixed plate 82 and the movable plate 83 are long ones having lengths equivalent to that of the FPD substrate 10 in the plate width direction.

In the spool shutter 81, the plurality of pressing mechanisms 85 are provided in the plate width direction. In each pressing mechanism 85, two rollers 86 for pressing both end portions of the movable plate 83 in the plate width direction and for enabling the movable plate 83 to move in a sliding direction, a support shaft 87 for supporting the rollers 86 in such a manner that the rollers 86 are rotatable, and holding members 88 which are fixed to the support plate 80 and which hold the support shaft 87 while pressing the support shaft 87 toward the fixed plate 82 are provided. The holding members 88 have springs 89 provided on top portions thereof. The support shaft 87 is pressed toward the fixed plate 82 by the pressing forces of the springs 89. As a result, the rollers 86 can press the movable plate 83 toward the fixed plate 82 to an appropriate pressing forces in which the movable plate 83 can slide.

Accordingly, in the spool shutter 81 having the above-described construction, the amount of evaporation material vapor flowing through each of the vapor holes 82a and 83b can be adjusted so that the distribution of the amount of evaporation material vapor in the plate width direction becomes uniform, by adjusting the sliding position of the movable plate 83 to adjust the relative position between each vapor hole 82a of the fixed plate 82 and the corresponding vapor hole 83a of the movable plate 83 (see Fig. 2B).

Further, a perforated plate shutter 24 is provided between the deposition chamber 14 and the mixing chamber 15, and a perforated straightening plate 27 is provided in the deposition chamber 14. The perforated plate shutter 24 includes a fixed plate 25 having a plurality of through holes 25a formed therein and a plurality of movable plates 26 which are provided in series in the plate width direction (direction of arrow Y) and in which a plurality of through holes 26a are formed at positions where the through holes 26a can be communicated with the through holes 25a. The flow rate of a gaseous mixture flowing through each of the through holes 25a and 26b is adjusted so that the distribution of the flow rate of the gaseous mixture flowing from the mixing chamber 15 to the deposition chamber 14 becomes uniform, by adjusting the position of each movable plate 26 in the plate width direction (direction of arrow Y) to adjust the relative position between the through holes 26a of each movable plate 26 and the corresponding through holes 25a of the fixed plate 25. In the perforated straightening plate 27, a plurality of through holes 27a are formed smaller than the through holes 25a and 26a. The perforated straightening plate 27 is intended to further straighten the flow rate distribution and flow of the gaseous mixture.

Accordingly, when the dopant material 30A and the host material 30B contained in the crucibles 22A and 22B are vaporized (sublimed) by radiant heat from the hot walls 23, which are the side walls (walls of the chamber 13) of the vaporizing chambers 16A and 16B heated by the electric heaters 17, the vapor of the dopant material flows into the mixing chamber 15 in a state in which the vapor amount distribution in the plate width direction is adjusted by the spool shutter 19,A, and the vapor of the host material flows into the mixing chamber 15 in a state in which the vapor amount distribution in the plate width direction is adjusted by the spool shutter 19B. In the mixing chamber 15, the vapor of the dopant material and the vapor of the host material are mixed to make a gaseous mixture having an appropriate mixing ratio. Moreover, this gaseous mixture passes through the perforated plate shutter 24 and the perforated straightening plate 27 to have a uniform distribution and is then evaporated (deposited) on the surface (to-be-coated region) of the FPD substrate 10 in the deposition chamber 14, whereby a thin film having a thickness of, for example, approximately 400 angstroms is formed. That is, a light emitting layer of organic EL elements is formed on the surface of the FPD substrate 10.

Here, it should be noted that though the surface of the FPD substrate 10 is coated at a time over the entire width thereof in the plate width direction, the surface thereof is successively coated in the substrate transport direction with the transport of the FPD substrate 10 by the substrate transport system, thus ultimately coating the entire to-be-coated region of the surface thereof. Further, since the FPD substrate 10 is a large-sized one having a plate width (width in the direction of arrow Y) of, for example, not less than 0.4 m (e.g., approximately 1 m), the length of the to-be-coated region on the surface of the FPD substrate 10 in the plate width direction is also long (e.g., 1 m). It should be noted that edge portions of the FPD substrate 10 on both sides in the plate width direction are portions touched by rollers of the substrate transport system and are therefore not-to-be-coated portions.

Accordingly, in accordance with the length of the to-be-coated region of the FPD substrate 10 in the plate width direction, the chamber 13, the deposition chamber 14 , the perforated straightening plate 25, the perforated plate shutter 24, the mixing chamber 15, the spool shutters 21, and the vaporizing chambers 16A and 16B are also long in the plate width direction to an extent equivalent to that of the to-be-coated region of the FPD substrate 10. The vaporizing chambers 16A and 16B are long narrow spaces having, for example, a length (width in the substrate transport direction) of approximately 0.05 m and a width (width in the plate width direction) of not less than 0.4 m (e.g., approximately 1 m).

Further, the crucibles 22A and 22B are also long narrow ones extending in the plate width direction in accordance with the long narrow to-be-coated region of the FPD substrate 10. Each of the crucibles 22A and 22B is a monolithic structure and made of materials having high thermal conductivity and heat resistance. Materials for such crucibles 22A and 22B include, for example, metals such as copper, aluminum, and SUS304, ceramic, silicon fluoride, and silicon nitride. It should be noted that the crucibles 22A and 22B have similar structures and therefore the structure of the crucible 22A will be described in detail below.

As illustrated in Figs. 1, 3, 4A, and 4B , the width (width in the plate width direction) of the crucible 22A is larger than the length (width in the substrate transport direction) thereof, and the crucible 22A has a rectangular shape in a top view (see Fig. 4A). For example, the crucible 22A has a long narrow shape having a length of 0.05 m and a width of not less than 0.4 m (e.g., 1m). Further, a plurality of (five in the example illustrated in the drawings) slit grooves' 32A are formed. in the upper surface 31 of the crucible 22A. These slit grooves 32A extend along the longitudinal direction (i.e., the plate width direction) of the crucible 22A and are formed over almost the entire width of the crucible 22A. Moreover, these slit grooves 32A are spaced in the direction (i.e., the substrate transport direction) perpendicular to the longitudinal direction of the crucible 22A. Portions between adjacent slit grooves 32A and the like (i.e., portions of the upper surface 31 of the crucible 22A where the slit grooves 32A are not formed) constitute mound portions 31a. As to the dimensions of the slit grooves 32A, for example, the width is approximately 1 to 5 mm, the length is not less than 0.4 m (e.g., approximately 1 m), and the depth is approximately 1 to 2 mm.

Moreover, these slit grooves 32A serve as portions for containing the evaporation material. That is, the slit grooves 32A of the crucible 22A contain the dopant material 30A, and the slit grooves 32A of the crucible 22B contain the host material 30B. It should be noted that the actual dimensions (width, depth, and length) and number of the slit grooves 32A are appropriately set depending on the actual required amount of the evaporation material (dopant material, host material), the actual dimensions of the to-be-coatedregion of the FPD substrate 10, and the like.

As described above, in the vacuum vapor deposition apparatus of the first embodiment, each of the crucibles 22A and 22H is a monolithic structure and a long narrow one extending along the plate width direction and has the plurality of slit grooves 32A in the upper surface 31 thereof, which slit grooves 32A extend along the longitudinal direction of the crucible 22A or 22b, and the slit grooves 32A serve as portions for containing the evaporation material (dopant material 30A, host material 30B). Accordingly, the heating surface areas (areas where the crucibles 22A and 22B are in contact with the evaporation materials) of the crucibles 22A and 22B become large. Thus, a desired vaporized amount of the evaporation material can be obtained without heating the hot walls to higher temperature, arranging a larger number of crucibles, and the like.

Further, since each of the crucibles 22A and 22B is a monolithic structure, even if there are differences in temperature among positions in the hot walls 23 in the longitudinal direction, temperature is uniform over the entire crucible 22A and over the entire crucible 22B due to heat conduction in portions (mound portions 31a) of the upper surfaces 31 of the crucibles 22A and 22B where the slit grooves 32A are not formed and portions under the slit grooves 32A. Accordingly, it is possible to prevent unevenness in the vaporization of the evaporation material (dopant material 30A, host material 30B) in the longitudinal direction and to make the film thickness distribution of the FPD substrate 10 uniform. That is, as illustrated in Fig. 4B, radiant heat from the hot walls 23 are not only received directly by the dopant material 30A but also received by the mound portions 31a of the crucible 22A. This heat is thermally conducted in the crucible 22A to be ultimately conducted to the dopant material 30A through the inner surfaces (heating surfaces) of the slit grooves 32A. The slit grooves 32A and the mound portions 31a are alternately placed to be close to each other. Thus, the temperatures of the dopant material 30A in the slit grooves 32A sensitively follow the temperatures of the mound portions 31a. If the amount of heat receiving from radiant heat does not fluctuate, the temperature of the dopant material 30A is maintained uniform and constant. The crucible 22B also has effects similar to the above-described ones.

Moreover, a small amount of the evaporation material (dopant material 30A, host material 30B) can also be easily dealt with by appropriately setting the number and dimensions (width, depth, and the like) of the slit grooves 32A.

Accordingly, an increase in the size of the to-be-coated region of the FPD substrate 10 which is associated with an increase in the size of the FPD substrate 10, a small amount of the evaporation material, and the like can be easily dealt with at low cost without heating the hot walls to higher temperature, arranging a larger number of crucibles, and the like. Thus, the cost of the apparatus can also be reduced.

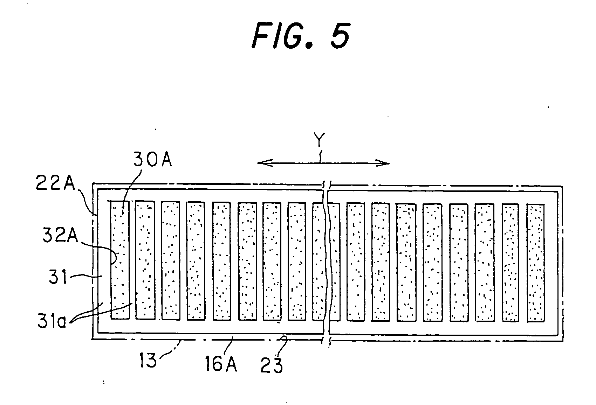

It should be noted that though the slit grooves 32A are formed along the longitudinal direction of the crucible 22A in the above-described example, the present invention is not necessarily limited to this. As illustrated in Fig. 5, the upper surface 31 of the crucible 22A may have a plurality of slit grooves 32A which extend along the direction perpendicular to the longitudinal direction and serve as portions for containing the dopant material. In this case, effects similar to the aforementioned ones can also be obtained. However, in this case, when the amount of the evaporation material to be contained in the slit grooves 32A is very small, the number of the slit grooves 32A becomes small, and the intervals between the slit grooves 32A in the longitudinal direction become too large. Accordingly, unevenness in the vaporization of the evaporation material in the longitudinal direction easily occurs. In view of such a case, it is more advantageous to form the slit grooves 32A along the longitudinal direction as described previously.

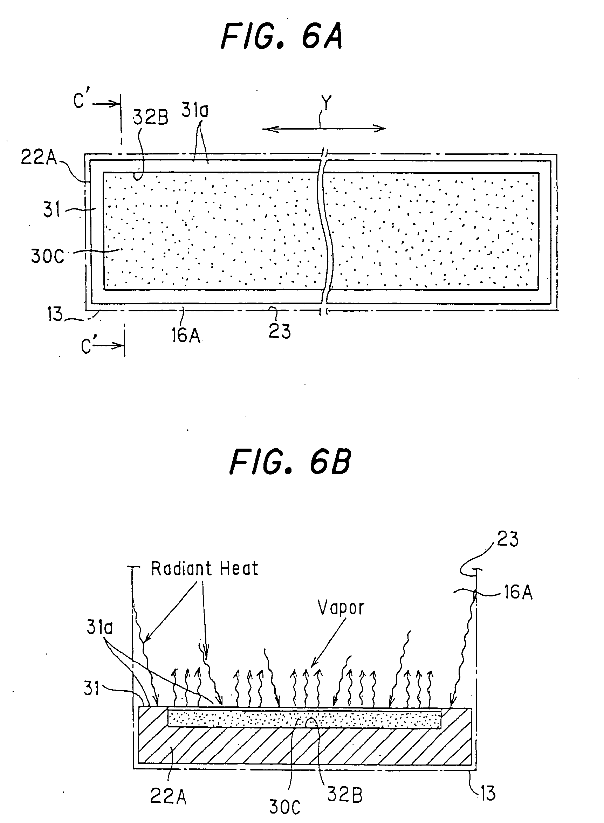

Further, in the case where the evaporation material is a sublimation material which is sublimed by heating to be vaporized, grooves as portions for containing the evaporation material are preferably a plurality of grooves which are narrow openings, i.e., the above-described slit grooves 32A, as illustrated in Figs. 4A to 5. This is because in the case where the sublimation material is used as the evaporation material, unevenness in the temperature of the sublimation material becomes smaller in a construction in which the contact area with the sublimation material is large, i.e.. a construction in which the plurality of slit grooves 32A are provided. On the other hand, in the case where the evaporation material is a molten material which is melted by heating to be vaporized, it is preferred that not the plurality of slit grooves 32A but one wide groove 32B which is provided in the upper surface of the monolithic crucible 22A extending over the entire area of the vaporizing chamber 16A and which has a length equivalent to that from one end of the crucible 22A to the other end thereof be used as a portion for containing the evaporation material, as illustrated in Figs. 6A and 6B. The reason is as follows: in the case where a molten material 30C is used as an evaporation material, the molten material 30C which is liquefied by melting has a constant vaporization area and a large contact surface with the groove 32B, and receives heat from the contact surface to vaporize; therefore, there is no need to use a plurality of slit grooves but even one slit groove is sufficient . It should be noted that in Figs. 6A and 6B, components equivalent to those of Figs. 4A and 4B are denoted by the same reference numerals and will not be further described here.

Moreover, for example, in the case where it is difficult to form a large monolithic crucible for a large workpiece such as a large-sized substrate, a large crucible as a single structure similar to the above-described monolithic crucible can be realized by arranging a plurality of crucibles in a cluster, placing the crucibles over the entire area of the vaporizing chamber, and forming a plurality of slit grooves having lengths from one end of the upper surface of the crucibles to the other end thereof in the upper surface of the crucibles. In order to further improve the uniformity of temperature distribution, it is preferred that the plurality of crucibles be placed in close proximity to each other to extend over the entire area of the vaporizing chamber when the crucibles are arranged in a cluster.

### [SECOND EMBODIMENT]

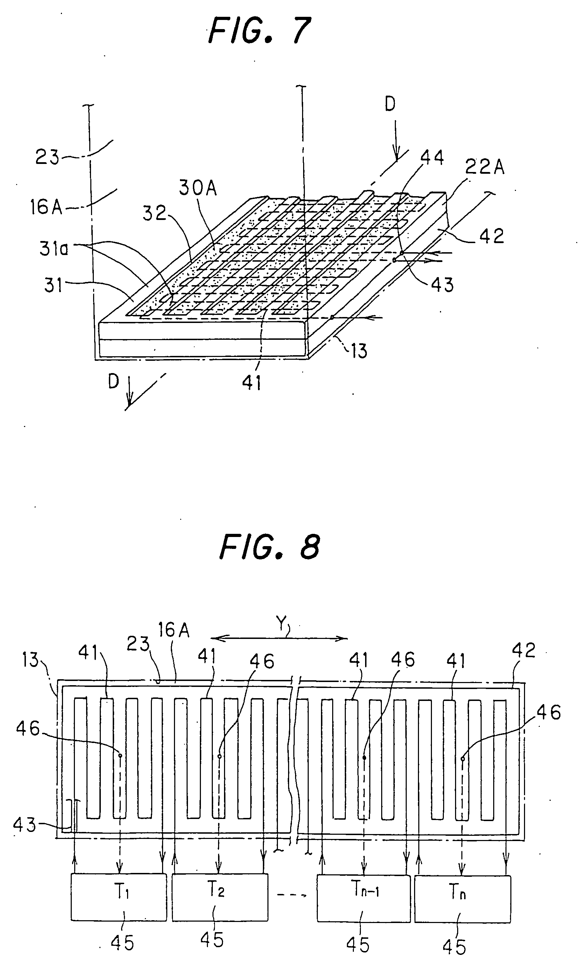

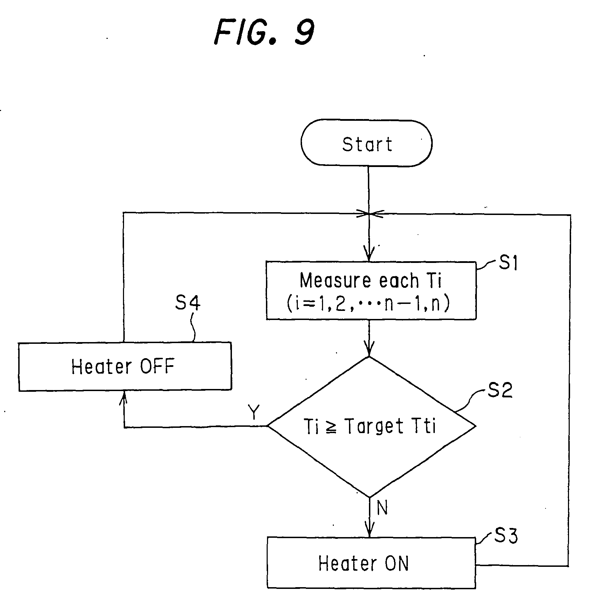

Fig. 7 is a perspective view illustrating the construction of an essential part of a vacuum vapor deposition apparatus according to a second embodiment of the present invention. Fig. 8 is a cross-sectional view (plan view of electric heaters) as seen from the direction of arrows D of Fig. 7. Fig. 9 is a flowchart for explaining temperature control.

In the vacuum vapor deposition apparatus of the second embodiment which is illustrated in Figs. 7 and 8, electric heaters 41 are further provided as heating means in the crucible 22A for a dopant material in the vacuum vapor deposition apparatus of the first embodiment . Though not illustrated, the crucible 22B for a host material also has a construction in which electric heaters 41 are provided as in the crucible 22A. Except for the above, the construction (the overall construction and arrangement of the crucibles, the overall construction of the vacuum vapor deposition apparatus, and the like) of the vacuum vapor deposition apparatus of the second embodiment is the same as that of the vacuum vapor deposition apparatus of the first embodiment (see Figs. 1 to 6B), and therefore will neither be illustrated nor described in detail here.

As illustrated in Figs. 7 and 8, a heater stage 42 is also provided under the lower surface of the crucible 22A to be integrated with the crucible 22A. Grooves 43 for heaters are formed in the upper surface of the heater stage 42. Grooves 44 for heaters are also formed in the lower surface of the crucible 22A. The electric heaters 41 are provided so as to be contained between the grooves 43 and 44. The plurality of electric heaters 41 are provided along the longitudinal direction of the crucible 22A. These electric heaters 41 are connected to individual temperature controllers 45, respectively. That is, the crucible 22A is divided into a plurality of regions in the longitudinal direction, and the individual electric heaters 41 are provided under the lower surface of the crucible 22A for the respective regions, whereby temperature can be individually controlled for the respective regions by the electric heaters 41. The temperature controllers 45 control powers to be supplied to the respective electric heaters 41 so that temperature detection signals (temperature detection values) of the crucible 22A for the respective regions, which are inputted from temperature sensors 46 such as thermocouples provided for the respective regions, indicate predetermined constant temperatures. The electric heaters 17 for heating the chamber 13 each have a capacity of, for example, 1 kW and can perform temperature regulation approximately from 0 to 350°C, whereas the electric heaters 41 each have a capacity of, for example, 0.01 kW and can perform temperature regulation approximately from 0 to 2°C.

Using the flowchart of Fig. 9, a specific example of the control of temperature regulation will be described. Temperature detection values Tᵢ (i=1, 2, ..., n-1, n) from the temperature sensors 46 for the respective regions of the crucible 22A are measured (step S1), and the temperature detection values Tᵢ for the respective regions and target temperature values Ttᵢ (i=1, 2, ..., n-1, n) for the respective regions are compared (step S2). If the temperature detection value Tᵢ is smaller than the target temperature value Ttᵢ in a certain region, heater output in the relevant region is controlled to be in an ON state (step S3). On the other hand, if the temperature detection value Ti is not less than the target temperature value Ttᵢ, the heater output in the relevant region is controlled to be in an OFF state (step S4). Thus, the electric heaters 41 are respectively controlled by the temperature controllers 45 so that the temperature detection values Ti for the respective regions indicate predetermined constant temperatures.

Accordingly, with the vacuum vapor deposition apparatus of the second embodiment, effects similar to those of the aforementioned first embodiment can also be obtained.

Furthermore, in the vacuum vapor deposition apparatus of the second embodiment, the crucible 22A is divided into a plurality of regions in the longitudinal direction, and the individual electric heaters 41 are provided under the lower surface of the crucible 22A for the respective regions, whereby temperature can be individually controlled for the respective regions by the electric heaters 41. Accordingly, for each region, the temperature of the crucible 22A is fine-tuned, and the temperature of the evaporation material (dopant material 30A) is fine-tuned. Thus, it is possible to more reliably prevent unevenness in the vaporization of the evaporation material (dopant material 30A) in the longitudinal direction. Consequently, it is possible to more reliably deal with an increase in the size of the to-be-coated region of the FPD substrate 10, a small amount of the evaporation material, and the like. The crucible 22B also has effects similar to the above-described ones.

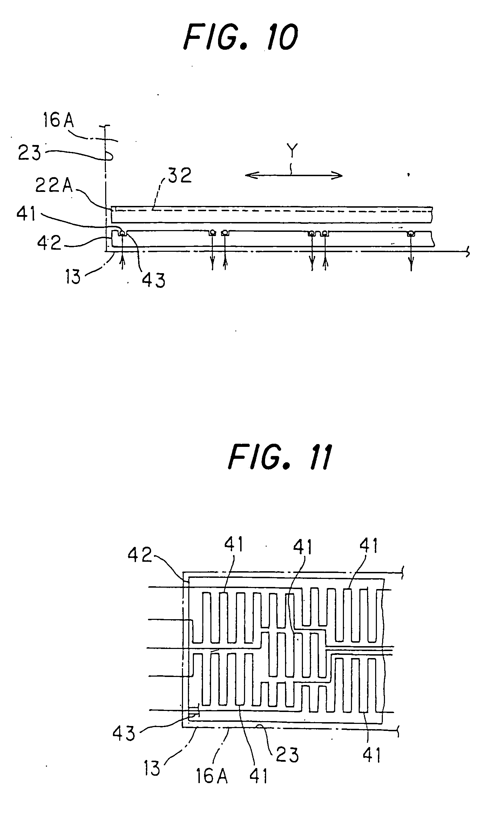

It should be noted that though in the above-described example, the crucible 22A and the heater stage 42 are integrated (i.e., the electric heaters 41 are of an embedded type) and the heat of the electric heaters 41 is transferred directly to the crucible 22A by the electric heaters 41 being in contact with the lower surface of the crucible 22A, the present invention is not limited to this. As illustrated in Fig. 10, the crucible 22A may be heated by radiant heat from the electric heaters 41 by providing the crucible 22A and the heater stage 42 as separate structures so that the electric heaters 41 are separated from the crucible 22A. In this case, the heater stage 42 (electric heaters 41) may be provided inside or outside the vaporizing chamber 16A (chamber 13). In the case where the heater stage 42 is provided inside the vaporizing chamber 16A (chamber 13), there is the advantage that the efficiency of heat transfer from the electric heaters 41 to the crucible 22A is high, because the walls of the vaporizing chamber 16A (chamber 13) do not exist between the crucible 22A and the electric heaters 41. On the other hand, in the case where the heater stage 42 is provided outside the vaporizing chamber 16A (chamber 13), there is the advantage that the maintenance, change, and the like of the heater stage 42 (electric heaters 41) are easy.

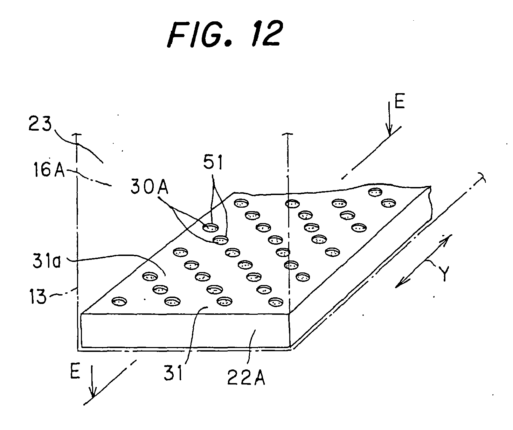

Moreover, the electric heaters 41 are not limited to being provided for the respective regions of the crucible 22A in the longitudinal direction as described previously, but may be more appropriately arranged. For example, as illustrated in Fig. 11, the crucible 22A may be divided into a plurality of regions not only in the longitudinal direction but also in the direction perpendicular to the longitudinal direction to provide individual electric heaters 41 under the lower surface of the crucible 22A for the respective regions, whereby temperature can be individually controlled for the respective regions by the electric heaters 41. In this case, finex temperature control can be performed because not only the temperature distribution of the crucible 22A in the longitudinal direction but also the temperature distribution thereof in the direction perpendicular to the longitudinal direction can be adjusted.

### [THIRD EMBODIMENT]

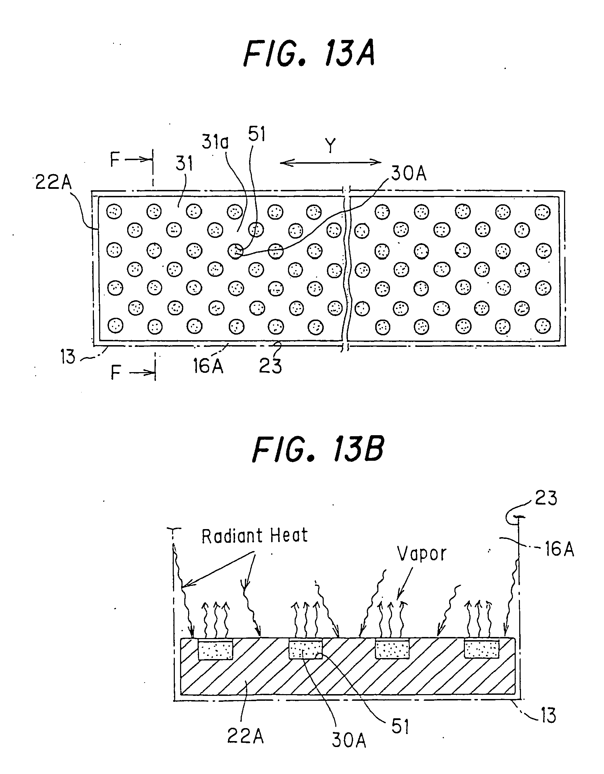

Fig. 12 is a perspective view illustrating the construction of an essential part of a vacuum vapor deposition apparatus according to a third embodiment of the present invention. Fig. 13A is a cross-sectional view (plan view of a crucible) as seen from the direction of arrows E of Fig. 12. Fig. 13B is an enlarged cross-sectional view taken along the line F-F of Fig. 13A.

As illustrated in Figs. 12 to 13B, in the vacuum vapor deposition apparatus of the third embodiment, instead of slit grooves, holes 51 are provided in the surface 31 of the crucible 22A for the dopant material in the vacuum vapor deposition apparatus of the aforementioned first embodiment. Although not shown, the crucible 22B for the host material also has a construction in which holes 51 are provided as in the crucible 22A. Except for the above, the construction (the arrangement of the crucibles, the overall construction of the vacuum vapor deposition apparatus, and the like) of the vacuum vapor deposition apparatus of the third embodiment is the same as that of the vacuum vapor deposition apparatus of the aforementioned first embodiment (see Figs. 1 to 6B) , and therefore will neither be illustrated nor described in detail here.

As illustrated in Figs. 12 to 13B, the width (width in the plate width direction) of the crucible 22A is larger than the length (width in the substrate transport direction) thereof , and the crucible 22A has a rectangular shape in a top view (see Fig. 13A). For example, the crucible 22A has a long narrow shape having a length of 0.05 m and a width of not less than 0.4 m (e.g., 1 m) . Further, a plurality of holes 51 are formed in the upper surface 31 of the crucible 22A. These holes 51 are formed over the entire upper surface 31 of the crucible 22A and arranged in a staggered array in the example illustrated in the drawings. These holes 51 are mutually spaced. Portions between adjacent holes 51 and the like (i.e. , portions of the upper surface 31 of the crucible 22A where the holes 51 are not formed) constitute mound portions 31a. As to the dimensions of the holes 51, for example, the diameter is approximately 1 to 5 mm, and the depth is approximately 0.1 to 2 mm.

Moreover, these holes 51 serve as portions for containing the evaporation material. That is, the holes 51 of the crucible 22A contain the dopant material 30A, and the holes 51 of the crucible 22B contain the host material 30B. It should be noted that the actual dimensions (diameter, depth, and the like) and number of the holes 51 are appropriately set depending on the actual required amount of the evaporation material (dopant material, host material), the actual dimensions of the to-be-coated region of the FPD substrate 10. and the like. Also, the shapes of the holes 51 in a top view are also not necessarily limited to circular shapes such as in the example illustrated in the drawings but may be appropriate shapes (e.g., rectangular shapes).

As described above, in the vacuum vapor deposition apparatus of the third embodiment, each of the crucibles 22A and 22B is a monolithic structure and a long narrow one extending along the plate width direction and has the plurality of holes 51 in the upper surface 31 thereof, and the holes 51 serve as portions for containing the evaporation material. Accordingly, the heating surface areas (areas where the crucibles 22A and 22B are in contact with the evaporation material) of the crucibles 22A and 22B become large. Thus, a desired vaporized amount of the evaporation material can be obtained without heating the hot walls to a higher temperature, arranging a larger number of crucibles, and the like.

Further, since each of the crucibles 22A and 22B is a monolithic structure, even if there are differences in temperature among positions in the hot walls 23 in the longitudinal direction of the crucibles 22A and 22B, the temperature is uniform over the entire crucible 22A and over the entire crucible 22B due to heat conduction in portions (mound portions 31a) of the upper surfaces 31 of the crucibles 22A and 22B where the holes 51 are not formed and portions under the holes 51. Accordingly, it is possible to prevent unevenness in the vaporization of the evaporation material (dopant material 30A, host material 30B) in the longitudinal direction and to make the film thickness distribution of the FPD substrate 10 uniform. That is, as illustrated in Fig. 13B, radiant heat from the hot walls 23 are not only received directly by the dopant material 30A but also received by the mound portions 31a of the crucible 22A. This heat is thermally conducted in the crucible 22A to be ultimately conducted to the dopant material 30A through the inner surfaces (heating surfaces) of the holes 51. The holes 51 and the mound portions 31a are alternately placed to be close to each other. Thus, the temperatures of the dopant material 30A in the holes 51 sensitively follow the temperatures of the mound portions 31a. If the amount of radiant heat received does not fluctuate, the temperature of the dopant material 30A is maintained uniform and constant. The crucible 22B also has effects similar to the above-described ones.
Moreover, a small amount of the evaporation material (dopant material 30A, host material 30B) can also be easily dealt with by appropriately setting the number and dimensions (diameter, depth, and the like) of the holes 51.

Accordingly, an increase in the size of the to-be-coated region of the FPD substrate 10 which is associated with an increase in the size of the FPD substrate 10, a small amount of the evaporation material, and the like can be easily dealt with at low cost without heating the hot walls to a higher temperature, arranging a larger number of crucibles, and the like. Thus, the cost of the apparatus can also be reduced. Also, in the third embodiment, even if the amount of the evaporation material is very small, the holes 51 can be provided in a dispersed manner over the entire upper surfaces of the crucibles 22A and 22B. Accordingly, the third embodiment is particularly effective for the case where the amount of the evaporation material is small, in comparison with the case where slit grooves are provided as in the aforementioned first embodiment.

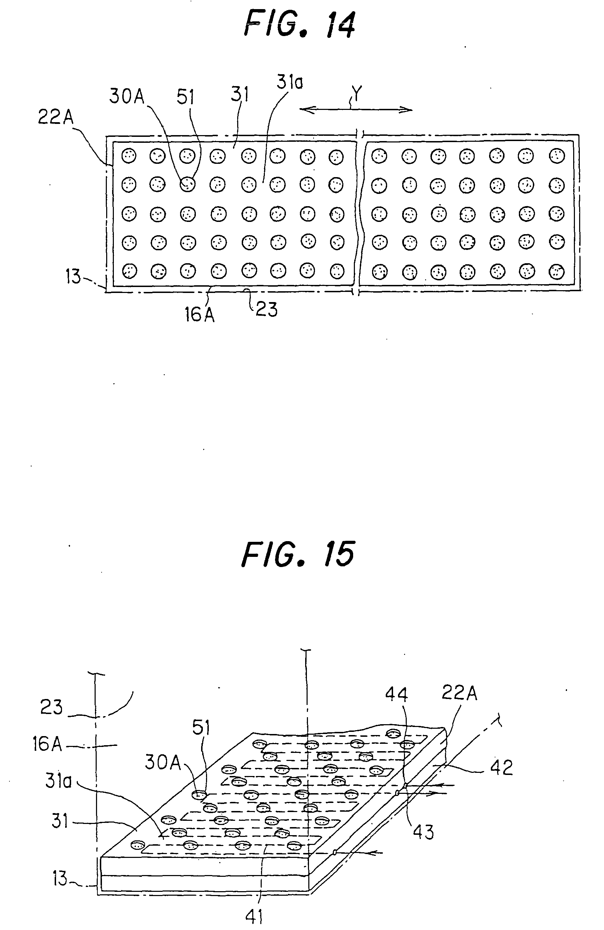

It should be noted that though the holes 51 are arranged in a staggered array in the above-described example, the arrangement thereof is not necessarily limited to this but may be an appropriate one. For example, an arrangement may be employed in which the holes 51 are simply arranged in columns and rows as illustrated in Fig. 14. In this case, effects similar to the above-described ones can also be obtained.

Moreover, for example, in the case where it is difficult to form a large monolithic crucible for a large workpiece such as a large-sized substrate, a large crucible as a single structure similar to the above-described monolithic crucible can be realized by arranging a plurality of crucibles in a cluster, placing the crucibles over the entire area of the vaporizing chamber, and forming a plurality of holes in the upper surface of the crucibles. In order to further improve the uniformity of temperature distribution, it is preferred that the plurality of crucibles be placed in close proximity to each other to extend over the entire area of the vaporizing chamber when the crucibles are arranged in a cluster.

### [FOURTH EMBODIMENT]

Fig. 15 is a perspective view illustrating the construction of an essential part of a vacuum vapor deposition apparatus according to a fourth embodiment of the present invention.

As described in Fig. 15, in the vacuum vapor deposition apparatus of the fourth embodiment, electric heaters 41 are further provided as heating means in the crucible 22A for the dopant material in the vacuum vapor deposition apparatus of the aforementioned third embodiment. Although not shown, the crucible 22B for the host material also has a construction in which electric heaters 41 are provided as in the crucible 22A. Except for the above, the construction (the overall construction and arrangement of the crucibles, the overall construction of the vacuum vapor deposition apparatus, and the like) of the vacuum vapor deposition apparatus of the fourth embodiment is the same as those of the vacuum vapor deposition apparatus of the aforementioned first and third embodiments (see Figs. 1 to 6B and Figs. 12 to 14), and therefore will neither be illustrated nor described in detail here.

Further, the arrangement and the like of the electric heaters 47, are also similar to those of the aforementioned second embodiment (see Figs. 7 to 11) and therefore will neither be illustrated nor described in detail here.

Accordingly, the vacuum vapor deposition apparatus of the fourth embodiment also has effects similar to those of the aforementioned first and third embodiments and further has effects similar to those of the aforementioned second embodiment.

### [OTHER EMBODIMENT]

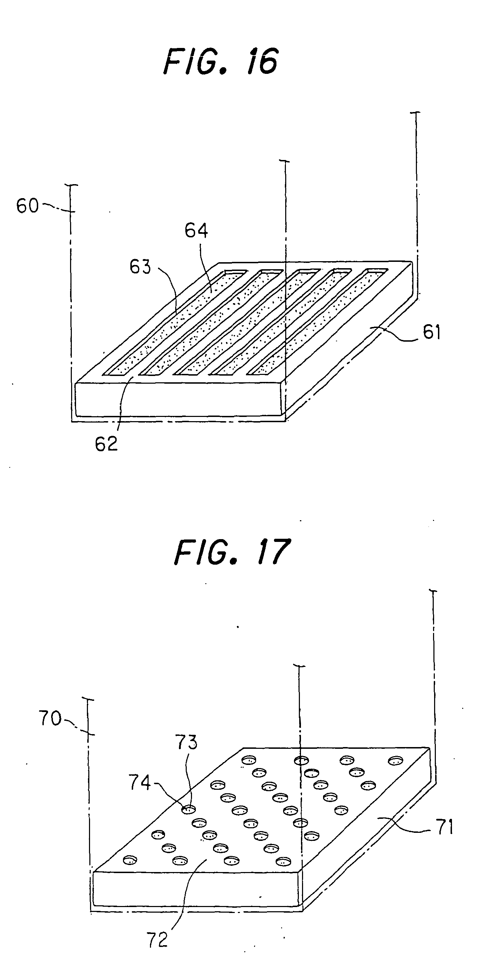

It should be noted that though effects of the present invention are particularly exerted in the case where the long narrow crucibles 22A and 22B are constructed in accordance with a long narrow to-be-coated region as in the above-described first to fourth embodiments, the present invention is not necessarily limited to the case where crucibles having such long narrow shapes are constructed. For example, as illustrated in Fig. 16, a plurality of slit grooves 63 may be formed as portions for containing an evaporation material 64 in the upper surface 62 of a crucible 61 which has a square shape (e.g., a square shape with a side length of several tens of centimeters) in a top view and which is provided in a vaporizing chamber 60. Alternatively, as illustrated in Fig. 17 , a plurality of holes 73 may be formed as portions for containing an evaporation material 74 in the upper surface 72 of a crucible 71 which has a square shape (e.g., a square shape with a side length of several tens of centimeters) in a top view and which is provided in a vaporizing chamber 70. Furthermore, the crucible 61 or 71 may be divided into a plurality of regions to provide individual heating means (electric heaters or the like) under the lower surface of the crucible 61 or 71 for the respective regions, whereby temperature can be individually controlled for the respective regions by the heating means. In this case, effects similar to the aforementioned ones can also be obtained. Further, an increase in the size of a to-be-coated region of a workpiece, a small amount of the evaporation material, and the like can also be easily dealt with at low cost without heating hot walls to a higher temperature, arranging a larger number of crucibles, and the like. Thus, the cost of a system can also be reduced.

Also, in the aforementioned first to fourth embodiments, examples have been disclosed in which the crucible 22A for the dopant material and the crucible 22B for the host material have similar constructions. However, crucibles disclosed in the aforementioned embodiments may be used in combination as follows: for example, a crucible in which the slit grooves 32A are formed as in the aforementioned first embodiment is employed as the crucible 22A for the dopant material, and a crucible in which the holes 51 are formed as in the aforementioned second embodiment is employed as the crucible 22B for the host material.

Moreover, the present invention can be applied to not only a vacuum vapor deposition apparatus for co-deposition but also a vacuum vapor deposition apparatus for single deposition. Furthermore, the present invention can also be applied to a vacuum vapor deposition apparatus other than a vacuum vapor deposition apparatus for organic EL.

The present invention relates to a vacuum vapor deposition apparatus. In particular, the present invention is useful in the case where the present invention is applied to a vacuum vapor deposition apparatus for organic EL in which the organic material (host material and dopant material) is deposited on a surface of a large-sized FPD substrate to form thin films of organic EL elements.

## Claims

1. A vacuum vapor deposition apparatus in which an evaporation material (30A, 30B) is contained in a crucible (22A, 22B) provided in a vaporizing chamber (16A, 16B) and hot walls being side walls of the vaporizing chamber (16A, 16B) heat the evaporation material (30A, 30B) by radiant heat from the hot walls (23) to vaporize the evaporation material and thereby the evaporation material (30A, 30B) is deposited on a surface of a workpiece (10) to form a thin film,
wherein the crucible (22A, 22B) is comprised of a monolithic structure extending over an entire area of the vaporizing chamber (16A, 16B) and has a plurality of grooves (32A) in an upper surface thereof, and the grooves (32A) have lengths from one end of the upper surface of the crucible (22A, 22B) to the other end thereof and serve as portions for containing the evaporation material (30A, 30B).

2. A vacuum vapor deposition apparatus in which an evaporation material (30A, 30B) is contained inacrucible (22A, 22B) provided in a vaporizing chamber (16A, 16B) and hot walls being side walls of the vaporizing chamber (16A, 16B) heat the evaporation material (30A, 30B) by radiant heat from the hot walls (23) to vaporize the evaporation material and thereby the evaporation material (30A, 30B) is deposited on a surface of a workpiece (10) to form a thin film,
wherein the crucible (22A. 22B) is comprised of a monolithic structure extending over an entire area of the vaporizing chamber (16A, 16B) and has a groove (32B) in an upper surface thereof, and the groove (32s) has a length from one end of the upper surface of the crucible (22A, 22B) to the other end thereof and serves as a portion for containing the evaporation material (30A, 30B).

3. A vacuum vapor deposition apparatus in which an evaporation material (30A, 30B) is contained in a crucible (22A, 22B) provided in a vaporizing chamber (16A, 16B) and hot walls being side walls of the vaporizing chamber (16A, 16B) heat the evaporation material (30A, 30B) by radiant heat from the hot walls (23) to vaporize the evaporation material and thereby the evaporation material (30A, 30B) is deposited on a surface of a worlepiece (10) to form a thin film,
wherein the crucible (22A, 22B) is comprised of a plurality of pieces arranged in a cluster to extend over an entire area of the vaporizing chamber (16A, 16B) and has a plurality of grooves (32A) in an upper surface thereof, and the grooves (32A) have lengths from one end of the upper surface of the crucible (22A, 22B) to the other end thereof and serve as portions for containing the evaporation material (30A, 30B).

4. A vacuum vapor deposition apparatus in which an evaporation material (30A, 30B) is contained in a crucible (22A, 22B) provided in a vaporizing chamber (16A, 16B) and hot walls being side walls of the vaporizing chamber (16A, 16B) heat the evaporation material (30A, 30B) by radiant heat from the hot walls (23) to vaporize the evaporation material and thereby the evaporation material (30A, 30B) is deposited on a surface of a workpiece (10) to form a thin film,
wherein the crucible (22A, 22B) is comprised of any of a monolithic structure extending over an entire area of the vaporizing chamber (16A, 16B) and a plurality of pieces arranged in a cluster to extend over the entire area of the vaporizing chamber and has a plurality of holes (51) in an upper surface thereof, and the holes (51) serve as portions for containing the evaporation material (30A, 30B).

5. The vacuum vapor deposition apparatus according to any one of claims 1 to 4,
wherein the crucible (22A, 22B) is divided into a plurality of regions, individual heating means (41) are provided under a lower surface of the crucible (22A, 22B) for the respective regions, and thus temperature can be individually controlled for the respective regions by the heating means.

6. A vacuum vapor deposition apparatus in which an evaporationmaterial (30A, 30B) is contained in a crucible (22A, 22B) provided in a vaporizing chamber (16A, 16B) and hot walls being side walls of the vaporizing chamber (16A, 16B) heat the evaporation material (30A, 30B) by radiant heat from the hot walls (23) to vaporize the evaporation material and thereby the evaporation material (30A, 30B) is deposited on a surface of a workpiece (10) to form a thin film,
wherein the crucible (22A, 22B) is comprised of a monolithic structure extending over an entire area of the vaporizing chamber (16A, 16B), has a long narrow shape extending along a width direction of the workpiece (10), and has at least one groove (32A, 32B) in an upper surface thereof; and the at least one groove (32A, 32B) extends along a longitudinal direction of the crucible (22A, 22B) and serves as a portion for containing the evaporation material (30A, 30B).

7. A vacuum vapor deposition apparatus in which an evaporation material (30A, 30B) is contained in a crucible (22A, 22B) provided in a vaporizing chamber (16A, 16B) and hot walls being side walls of the vaporizing chamber (16A, 16B) heat the evaporation material (30A, 30B) by radiant heat from the hot walls (23) to vaporize the evaporation material and thereby the evaporation material (30A, 30B) is deposited on a surface of a workplace (10) to form a thin film,
wherein the crucible (22A, 22B) is comprised of a monolithic structure extending over an entire area of the vaporizing chamber (16A, 16B), has a long narrow shape extending along a width direction or the workpiece (10), and has a plurality of grooves (32A) in an upper surface thereof; and the grooves (32A) extend along a direction perpendicular to a longitudinal direction of the crucible (22A, 22B) and serve as portions for containing the evaporation material (30A, 30B).

8. A vacuum vapor deposition apparatus in which an evaporationmaterial (30A, 30B) is contained in a crucible (22A, 22B) provided in a vaporizing chamber (16A, 16B) and hot walls being side walls of the vaporizing chamber (16A, 16B) heat the evaporation material (30A, 30B) by radiant heat from the hot walls (23) to vaporize the evaporation material and thereby the evaporation material (30A, 30B) is deposited on a surface of a workpiece (10) to form a thin film,
wherein the crucible (22A, 22B) is comprised of a monolithic structure extending over an entire area of the vaporizing chamber (16A, 16B), has a long narrow shape extending along a width direction of the workpiece (10), and has a plurality of holes (51) in an upper surface thereof; and the holes (51) serve as portions for containing the evaporation material (30A, 30B).

9. The vacuum vapor deposition apparatus according to any one of claims 6 to 8,
wherein the crucible (22A, 22B) is divided into a plurality of regions at least in the longitudinal direction, individual heating means (41) are provided under a lower surface of the crucible (22A, 22B) for the respective regions, and thus temperature can be individually controlled for the respective regions by the heating means (41).

10. The vacuum vapor deposition apparatus according to any one of claims 6 to 9,
wherein the evaporation material (30A, 30B) is an organic material, and
the workpiece (10) is a substrate for a flat panel display, and the organic material is deposited on a surface of the substrate to form a thin film of an organic electroluminescence element.

11. The vacuum vapor deposition apparatus according to any one of claims 6 to 9,
wherein the evaporation material (30A, 30B) is the organic material, and
the workpiece (10) is a substrate for a lighting device, and the organic material is deposited on a surface of the substrate to form a thin film of an organic electroluminescence element.

12. A method of manufacturing a thin film of an organic electroluminescence element using the vacuum vapor deposition apparatus according to any one of claims 5 and 9,
wherein an organic material is used as the evaporation material (30A, 30B), and
temperatures are measured for the respective regions of the crucible (22A, 22B), and outputs of the heating means (41) are individually controlled based on the measured temperatures of the respective regions so that the temperatures of the respective regions become constant.
